## Europäisches Patentamt
## European Patent Office
## Office européen des brevets

(11) Numéro de publication: **0 143 694**
**B1**

(12)
# FASCICULE DE BREVET EUROPÉEN

(45) Date de publication du fascicule du brevet:
22.07.87

(21) Numéro de dépôt: 84402323.4

(22) Date de dépôt: 14.11.84

(51) Int. Cl.⁴: **C 30 B 11/00,** C 30 B 29/52, C 22 C 19/05

(54) **Superalliage monocristallin à base de nickel, à faible masse volumique, et aube de turbomachine en ce superalliage.**

(30) Priorité: 18.11.83 FR 8318421

(43) Date de publication de la demande:
05.06.85 Bulletin 85/23

(45) Mention de la délivrance du brevet:
22.07.87 Bulletin 87/30

(84) Etats contractants désignés:
CH DE GB IT LI NL SE

(56) Documents cité:
FR-A-2 503 188
FR-A-2 512 837
GB-A-2 106 138

(73) Titulaire: **Office National d'Etudes et de Recherches Aerospatiales (O.N.E.R.A.), 29 Avenue de la Division Leclerc, F-92320 Châtillon-sous-Bagneux (FR)**

(72) Inventeur: **Khan, Tasadduq, 18, Parc de Diane, F-78350 Jouy en Josas (FR)**
Inventeur: **Caron, Pierre, 13, allée des Bathes, F-91940 Les Ulis (FR)**
Inventeur: **Raffestin, Jean-Louis, 10, Résidence du Bois du Roi, F-91940 Les Ulis (FR)**

(74) Mandataire: **Rousset, Jean-Claude, Cabinet Netter 40, rue Vignon, F-75009 Paris (FR)**

EP 0 143 694 B1

## Description

L'invention a pour objet une composition particulière de superalliage à base de nickel, apte à la solidification monocristalline notamment pour la fabrication d'aubes mobiles de turbomachines.

Elle vise à fournir un alliage présentant simultanément, par rapport aux superalliages les plus performants actuellement utilisés pour réaliser les aubes de turbomachines, une masse volumique inférieure à ceux-ci et une caractéristique spécifique de fluage, exprimée par la valeur de résistance au fluage à chaud rapportée à la masse volumique, supérieure à celles desdits superalliages.

Le superalliage le plus performant actuellement en production est celui qui porte la référence PWA 1422 (DS 200 + Hf). Sa masse volumique est 8,55 g/cm³. C'est un alliage à grains colonnaires obtenu par solidification dirigée qui présente une bonne résistance aux sollicitations dans une direction parallèle aux joints de grains.

De nombreux travaux sont actuellement en cours pour la mise au point de compositions nouvelles adaptées à l'élaboration d'aubes monocristallines par solidification dirigée.

Un des meilleurs alliages proposés est désigné sous la référence PWA 1480 (ou alliage 454) et sa masse volumique est 8,7 g/cm³.

A l'égard de la résistance au fluage, cet alliage procure, par rapport à l'alliage à grains colonnaires déjà cité (PWA 1422) un gain en température allant de 20 à 50°C selon la zone de température considérée.

Cette propriété résulte de la composition de l'alliage (PWA 1480) et aussi des traitements thermiques de précipitation, tels que ceux décrits dans la Demande de Brevet français 2 503 188 du Demandeur, appliqués aux pièces en cet alliage après la solidification monocristalline, et qui conduisent à la formation d'un précipité de la phase $\gamma'$, dont la dimension moyenne des grains est 5000 ångströms.

Cependant, pour les alliages destinés à constituer des aubes mobiles de turbomachines, seules les caractéristiques spécifiques ont une réelle importance pratique compte tenu du fait que la masse volumique de l'alliage doit être maintenue la plus faible possible afin de minimiser les contraintes centrifuges sur les aubes mobiles de turbomachines.

En effet, il est admis qu'une augmentation de la masse volumique d'environ 10 % conduirait à une réduction par un facteur 3 de la durée de vie du disque sur lequel les aubes sont montées.

A l'inverse, une diminution de la masse volumique entraîne un allègement de l'ensemble aubes-disque favorisant l'amélioration des performances de la turbomachine.

Mais jusqu'à présent les masses volumiques des superalliages monocristallins connus à hautes caractéristiques de fluage sont de l'ordre de 8,6 g/cm³.

Un but de la présente invention est une composition d'alliage qui permet d'aboutir à des pièces monocristallines dont les caractéristiques spécifiques en fluage sont supérieures à celles de l'alliage connu sous la référence 454 mais dont la masse volumique ne dépasse pas 8,25 g/cm³, c'est-à-dire soit environ 5 % plus faible que celle dudit alliage connu.

D'une manière générale, il est admis qu'une amélioration de la résistance au fluage à chaud est obtenue par des additions massives d'éléments réfractaires tels que le Ta, le W et le Mo ou le Re.

C'est ainsi que l'alliage monocristallin le plus résistant entré dans une phase d'industrialisation (alliage 454) contient 12 % de Ta et 4 % de W.

De même, l'alliage DS 200 + Hf contient 12 % de W.

Ces éléments réfractaires jouent un rôle important en diminuant la vitesse de fluage, augmentant proportionnellement les durées de vie en fonctionnement.

Ces éléments ont en effet des vitesses de diffusion très faibles, même à haute température, ce qui conduit à un ralentissement de la vitesse de coalescence de la phase $\gamma'$, ou phase durcissante, $Ni_3$ (Al, Ti...) dont dépend la résistance de l'alliage au fluage à chaud.

Mais ces éléments réfractaires, très lourds, s'ils produisent une augmentation de la résistance au fluage à chaud, présentent l'inconvénient d'augmenter simultanément la masse volumique de l'alliage.

On peut concevoir, pour diminuer la masse volumique de l'alliage, d'introduire des quantités importantes d'éléments légers, en particulier d'aluminium, mais on aboutit à une précipitation primaire de la phase $\gamma'$ et l'alliage ne peut pas présenter les caractéristiques de fluage requises.

Les travaux du Demandeur, dans le domaine des superalliages pour aubes de turbomachines, l'ont conduit à considérer d'une part une somme S1 relative aux éléments réfractaires, à savoir:

$$S1 = 0,5W + Ta + Mo$$

dans laquelle les symboles littéraux représentent la fraction pondérale des éléments chimiques correspondants;

d'autre part une somme S2 relative aux éléments qui participent à la formation de la phase durcissante $\gamma'$, à savoir

$$S2 = Al + Ti + Ta + Nb + V$$

dans laquelle les symboles représentent la fraction atomique des éléments.

Le Demandeur a déterminé, pour tenir compte des exigences contradictoires relatives à la masse volumique et à la résistance au fluage, les conditions que doivent respecter les valeurs de S1 et de S2 pour aboutir à des alliages de qualité optimale. Ces conditions sont:

S1 compriseentre 4 et 9 % en poids et de préférence entre 5,5 et 9 % en poids

et S2 comprise entre 14,9 et 20,6 atomes %, et de préférence entre 16,5 et 18,5 atomes %.

La part du vanadium entrant dans la somme S2 a pour résultat un élargissement de la fenêtre de traitement thermique, c'est-à-dire de l'intervalle de température entre la fin de la mise en solution de la phase γ' et le point de fusion commençante de l'alliage, ce qui est avantageux lorsque les traitements thermiques sont effectuée dans un cadre industriel.

On s'est abstenu d'incorporer dans l'alliage du C, du B et du Zr, évitant ainsi de diminuer la température de fusion commençante de l'alliage et permettant, au cours du traitement thermique, d'amener la pièce à une température suffisamment élevée pour que soit remise en solution la phase γ' ainsi que la quasi-totalité de l'eutectique γ/γ', l'ensemble étant ensuite, au cours du refroidissement, précipité sous forme de fines particules γ'.

Un alliage selon l'invention satisfaisant les conditions cidessus pour S1 et S2 a une composition qui répond au tableau suivant où les proportions sont exprimées en pourcentages pondéraux:

Co: 5 à 7 %
Cr : 5 à 10 %
Mo : 0,5 à 2,5 %
W : 3 à 5 %
Al : 6 à 7,5 %
Ti : 1,5 à 2,25 %
Nb : 0 à 0,5 %
Ta : 2 à 4 %
V : 0,3 à 0,6 %
Ni : complément à 100 %.

sans addition volontaire de
B, C, Zr.

Après élaboration conduisant à l'aube monocristalline, celle-ci est soumise à un traitement thermique de mise en solution de la phase γ'. Ce traitement consiste à porter la pièce à une température comprise entre 1290 et 1325°C, selon sa composition, pendant un temps compris entre 30 minutes et quatre heures.

La pièce est alors refroidie à l'air. On applique ensuite un traitement thermique de précipitation de la phase γ' en portant la pièce à une température supérieure à 1000°C pendant plusieurs heures, après mise en solution complète de cette phase dans la solution solide γ, comme décrit dans le Brevet français 2 503 168 déposé le 3 avril 1981.

On obtient ainsi une distribution régulière des particules γ', dont la dimension moyenne est de 0,5 μm.

Ces particules sont alignées suivant les directions cristal, lographiques du type < 100 >.

**Exemple 1:**

La composition de l'alliage est la suivante:

Co : 5 %
Cr : 7 %
Mo : 2,25 %
W : 4 %
Al : 6 %
Ti : 2 %
Ta : 4 %
V : 0,5 %
Ni : Complément à 100 %.

La masse volumique de cet alliage est de 8,23 $g/cm^3$.

La température de mise en solution totale de la phase γ' est d'environ 1295°C.

La température de fusion commençante de l'alliage est d'environ 1317°C.

La différence relativement importante entre ces deux températures (ou fenêtre de traitement thermique), égale à 22°C, est nettement supérieure à celle des autres alliages monocristallins connus.

La présence de vanadium, simultanée à celle des autres composants, quoiqu'en très faible quantité (0,5 %), conduit à une excellente résistance au fluage à très haute température.

**Exemple 2:**

On part d'un alliage dont la composition est la suivante:

Co: 5 %
Cr : 7 %
Mo : 2,25 %
W : 4 %
Al : 6 %
Ti : 2 %
Ta : 3 %
V : 0,5 %
Nb : 0,5 %
Ni : complément à 100 %.

La masse volumique de l'alliage est de 8,20 $g/cm^3$.

La température de mise en solution complète de la phase γ' est d'environ 1290°C et la température de fusion commençante est de 1310°C, la fenêtre de traitement thermique étant ainsi de 20°C.

Pour d'autres compositions selon l'invention qui ont été essayées, les fenêtres de traitement thermique sont toujours supérieures à 10°C.

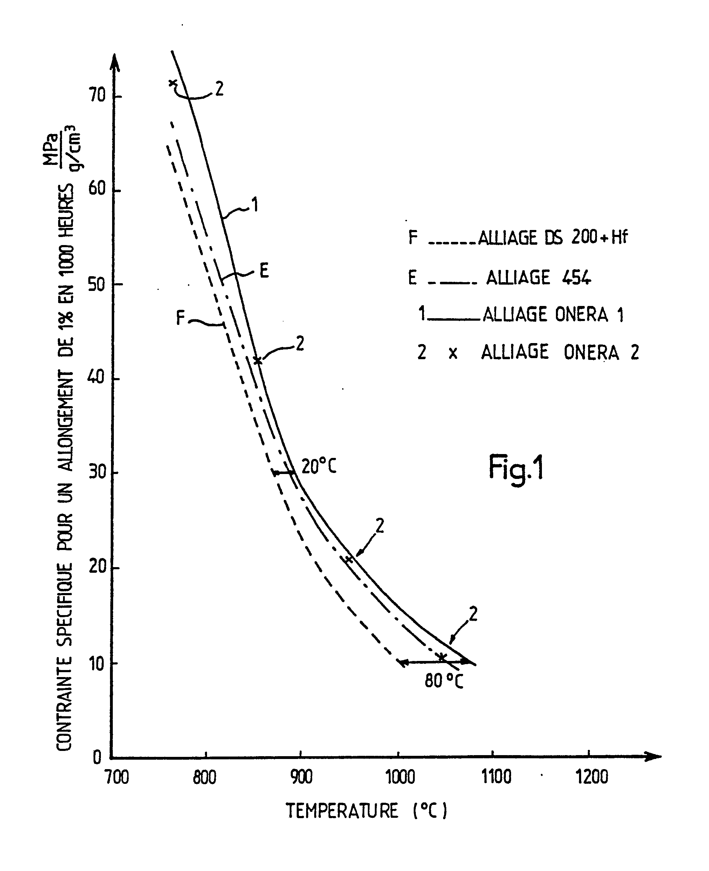

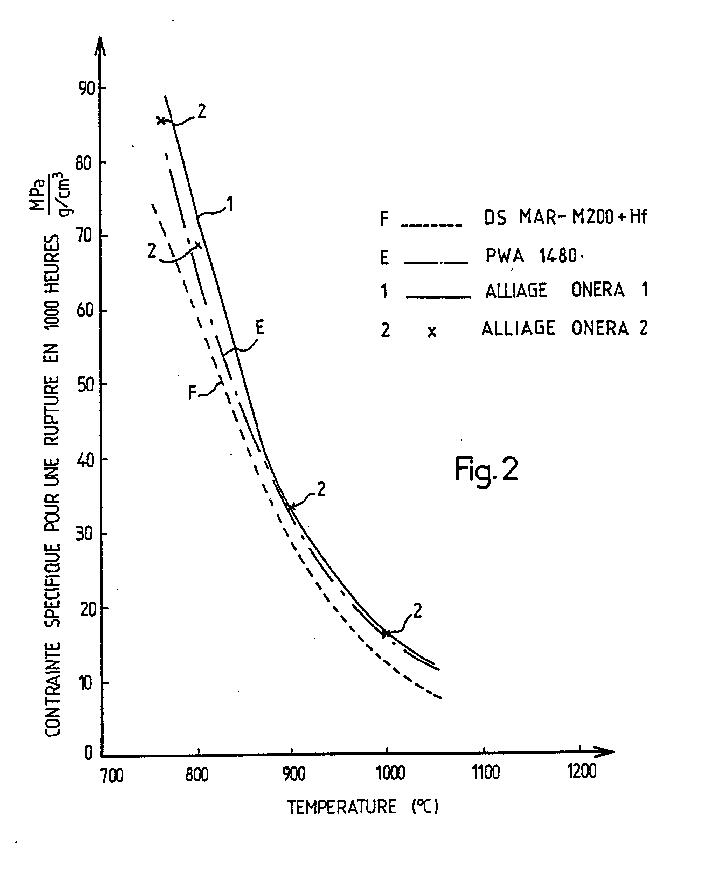

Sur les figures 1 et 2, on a tracé des courbes qui définissent, pour les alliages des Exemples 1 et 2, la résistance au fluage à chaud et cela comparativement à deux des meilleurs alliages connus antérieurement, à savoir:
- l'alliage PWA 1480 ou 454 ou alliage E
- l'alliage PWA 1422 ou DS 200 + Hf ou alliage F.

La figure 1 montre des diagrammes obtenus pour les quatre alliages en portant en abscisses la températures en degrés C et en ordonnées la contrainte spécifique, c'est-à-dire la contrainte rapportée à la masse spécifique, à laquelle l'alliage est soumis pour un allongement de 1 % en 1000 heures.

La courbe 1 traduit le résultat des expériences conduites sur une éprouvette en alliage ayant la composition définie dans l'exemple 1 et ayant subi le traitement thermique défini dans la Demande de Brevet 2 503 188.

Un alliage ayant la composition définie dans l'Exemple 2 et ayant subi le même traitement thermique conduit aux résultats représentés par les croix 2.

La courbe E traduit les résultats d'expériences conduites sur une éprouvette en alliage 454.

La courbe F traduit les résultats d'expériences conduites sur une éprouvette en l'alliage à grains colonnaires DS 200 + Hf.

Il est à constater que, sur toute l'étendue de température d'utilisation, les alliages en les compositions des Exemples 1 et 2 de l'invention présentent des qualités supérieures à l'un et l'autre des deux alliages connus.

De la considération de ces courbes, on tire, par exemple, que l'alliage de l'Exemple 1 offre un gain de température de 20°C sur l'alliage DS 200 + Hf dans la zone de température voisine de 900°C.

Il offre un gain de 80° par rapport à l'aliage DS 200 + Hf dans la zone de température voisine de 1000°C.

Il présente en outre l'avantage d'avoir une masse volumique nettement plus faible, à savoir 8,23 au lieu de 8,55 g/cm³ pour l'alliage DS 200 + Hf.

Par rapport à l'alliage monocristallin 454, dont la masse volumique est 8,70:

l'alliage 1 a des propriétés de fluage nettement supérieures à cet alliage monocristallin en dessous de 850°C et légèrement supérieures au-delà de 950°C.

La figure 2 montre des diagrammes analogues à ceux de la figure 1, mais dans lequel on a porté, en ordonnées, la contrainte spécifique des alliages pour une rupture en 1000 heures, la température en degrés C étant encore portée en abscisses.

La supériorité de l'alliage selon l'invention sur les alliages antérieurement connus est confirmée.

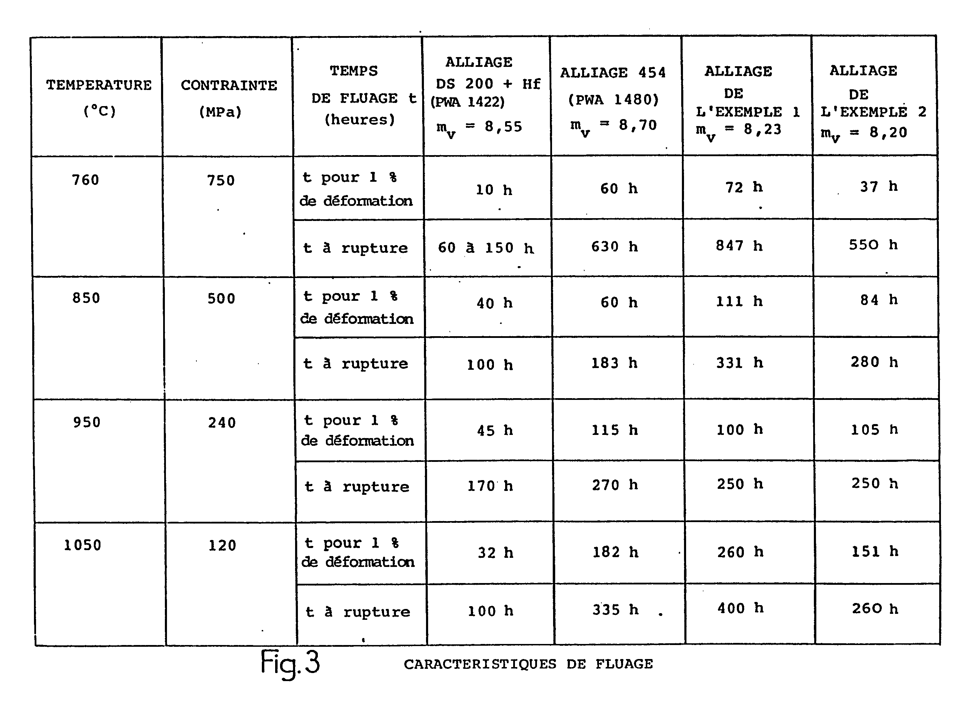

La figure 3 est un tableau dans lequel on a porté, pour les deux alliages connus considérés précédemment, et pour les alliages correspondant aux Exemples 1 et 2, les valeurs de la contrainte correspondant au temps de fluage pour aboutir respectivement à 1 % de déformatiom et à la rupture, et cela à différentes températures.

Même sans tenir compte de l'avantage qui résulte de la faible masse volumique des alliages selon l'invention, l'alliage de l'Exemple 1 possède une résistance au fluage aussi élevée que celle de l'alliage 454 aux températures moyennes (jusqu'à 950°C) et nettement supérieure à très haute température.

Par ailleurs, une diminution de la masse volumique entraîne un gain de masse sur l'ensemble aubes-disque favorable à l'amélioration des performances de la turbomachine équipée par ces aubes.

Un gain de 5 % en masse volumique, comme procuré par la composition selon l'invention a, à cet égard, une influence significative.

**Revendications**

1. Superalliage à base de nickel, à faible masse volumique et à hautes caractéristiques en fluage à chaud, destiné notamment à la solidification monocristalline pour l'obtention de pièces de turbomachines, caractérisé en ce que sa composition pondérale en % répond aux conditions suivantes:

Co : 5   à 7 %
W : 3   à 5 %
Nb: 0   à 0,5 %
Cr : 5   à 10 %
Al : 6   à 7,5 %
Ta : 2   à 4 %
Mo : 0,5   à 2,5 %
Ti : 1,5   à 2,25 %
V : 0,3   à 0,6 %
Ni : complément à 100 %.

2. Superalliage selon la revendication 1, caractérisé en ce que sa composition pondérale est la suivante:

Co : 5 %
W : 4 %
Al : 6 %
Cr : 7 %
Ti : 2 %
Mo : 2,25 %
Ta : 4 %
V : 0,5 %
Ni : complément à 100 %.

3. Superalliage selon la revendication 1, caractérisé en ce que sa composition pondérale est la suivante:

Co : 5 %
W : 4 %
Al : 6 %
Nb : 0,5 %
Cr : 7 %
Mo : 2,25 %
Ti : 2 %
Ta : 3 %
V : 0,5 %
Ni : complément à 100 %.

4. Pièce, notamment aube de turbomachine, en un superalliage selon l'une des revendications 1 à 3, caractérisée en ce qu'elle a subi un traitement thermique de précipitation de la phase γ' pendant plusieurs heures a une temperature supérieure à 1000°C.

5. Pièce selon la revendication 4, caractérisée en ce que le traitement thermique comporte la mise en solution de la phase γ' à une température comprise entre 1290 et 1325°C.

6. Procédé pour la fabrication d'une pièce selon la revendication 4 ou la revendication 5, caractérisé en ce que partant d'un superalliage selon l'une des revendications 1 à 3 amené à fusion, on en provoque la solidification monocristalline et en ce qu'on soumet la pièce obtenue à un traitement thermique de précipitation de la phase γ' pendant plusieurs heures à une température supérieure à 1000°C.

**Patentansprüche**

1. Superlegierung auf Nickel-Basis mit niedrigem spezifischen Gewicht und guten Warmfließeigenschaften, insbesondere für die monokristalline Erstarrung zur Erzeugung von Strömungsmaschinen- Bauteilen, gekennzeichnet durch folgende Zusammensetzung in Gewichtsprozent:

Co : 5    à 7 %
W : 3    à 5 %
Nb : 0    à 0,5 %
Cr : 5    à 10 %
Al : 6    à 7,5 %
Ta : 2    à 4 %
Mo : 0,5    à 2,5 %
Ti : 1,5    à 2,25 %
V : 0,3    à 0,6 %
Rest: Nickel

2. Superlegierung nach Anspruch 1, gekennzeichnet durch folgende Zusammensetzung in Gewichtsprozent:

Co : 5 %
W : 4 %
Al : 6 %
Cr : 7 %
Ti : 2 %
Mo : 2,25 %
Ta : 4 %
V : 0,5 %
Rest: Nickel

3. Superlegierung nach Anspruch 1, gekennzeichnet durch folgende Zusammensetzung in Gewichtsprozent:

Co : 5 %
W : 4 %
Al: 6%
Nb : 0,5 %
Cr : 7 %
Mo : 2,25 %
Ti : 2 %

Ta : 3 %
V : 0,5 %
Rest: Nickel

4. Bauteil für Strömungsmaschinen, insbesondere Schaufel, aus einer Superlegierung gemäß einem der Ansprüche 1 bis 3, dadurch gekennzeichnet, daß sie einer thermischen Behandlung der Ausscheidung der γ'-Phase während mehrerer Stunden bei einer Temperatur oberhalb 1000°C unterworfen wird.

5. Bauteil nach Anspruch 4, dadurch gekennzeichnet, daß die thermische Behandlung das in Lösunggehen der γ'-Phase bei einer Temperatur zwischen 1290 und 1325°C umfaßt.

6. Verfahren zur Herstellung eines Bauteils nach Anspruch 4 oder 5, dadurch gekennzeichnet, daß ausgehend von einer zum Schmelzen gebrachten Superlegierung nach einem der Ansprüche 1 bis 3 eine monokristalline Erstarrung eingeleitet wird und daß das erhaltene Bauteil einer thermischen Ausscheidungsbehandlung der γ'-Phase während mehrerer Stunden bei einer Temperatur größer 1000°C unterworfen wird.

**Claims**

1. Superalloy based on nickel, having a low density and high hot-flow characteristics and intended, in particular, for monocrystalline solidification for the production of parts for turbo-engines, characterized in that its percentage composition by weight corresponds to the following conditions:

Co : 5 to 7 %
W : 3 to 5 %
Nb : 0 to 0.5 %
Cr : 5 to 10 %
Al : 6 to 7.5 %
Ta : 2 to 4 %
Mo : 0.5 to 2.5 %
Ti : 1.5 to 2.25 %
V : 0.3 to 0.6 %
Ni : remainder to 100 %.

2. Superalloy according to Claim 1, characterized in that its composition by weight is as follows:

Co : 5 %
W : 4 %
Al : 6 %
Cr : 7 %
Ti : 2 %
Mo: 2.25 %
Ta : 4 %
V : 0.5 %
Ni: remainder to 100 %.

3. Superalloy according to Claim 1, characterized in that its composition by weight is as follows:

Co : 5 %
W : 4 %
Al : 6 %
Nb : 0.5 %
Cr : 7 %
Mo : 2.25 %
Ti : 2 %
Ta : 3 %
V : 0.5 %
Ni : remainder to 100%.

4. Part, in particular, turbo-engine blade, made of a superalloy according to one of Claims 1 to 3, characterized in that it has undergone a heat treatment for precipitation of the γ' phase for several hours at a temperature above 1000°C.

5. Part according to Claim 4, characterized in that the heat treatment incorporates bringing the γ' phase into solution at a temperature of between 1290 and 1325°C.

6. Process for the manufacture of a part according to Claim 4 or Claim 5, characterized in that, using a superalloy according to one of Claims 1 to 3 brought to melting, it is caused to undergo monocrystalline solidification, and in that the part obtained is subjected to a heat treatment for precipitation of the γ' phase for several hours at a temperature above 1000°C.

Fig.1

Legend:
- F ....... ALLIAGE DS 200+Hf
- E _._._ ALLIAGE 454
- 1 _____ ALLIAGE ONERA 1
- 2  x  ALLIAGE ONERA 2

Y-axis: CONTRAINTE SPECIFIQUE POUR UN ALLONGEMENT DE 1% EN 1000 HEURES $\frac{MPa}{g/cm^3}$

X-axis: TEMPERATURE (°C)

Fig. 2

| TEMPERATURE (°C) | CONTRAINTE (MPa) | TEMPS DE FLUAGE t (heures) | ALLIAGE DS 200 + Hf (PWA 1422) $m_v = 8,55$ | ALLIAGE 454 (PWA 1480) $m_v = 8,70$ | ALLIAGE DE L'EXEMPLE 1 $m_v = 8,23$ | ALLIAGE DE L'EXEMPLE 2 $m_v = 8,20$ |
|---|---|---|---|---|---|---|
| 760 | 750 | t pour 1 % de déformation | 10 h | 60 h | 72 h | 37 h |
| | | t à rupture | 60 à 150 h | 630 h | 847 h | 550 h |
| 850 | 500 | t pour 1 % de déformation | 40 h | 60 h | 111 h | 84 h |
| | | t à rupture | 100 h | 183 h | 331 h | 280 h |
| 950 | 240 | t pour 1 % de déformation | 45 h | 115 h | 100 h | 105 h |
| | | t à rupture | 170 h | 270 h | 250 h | 250 h |
| 1050 | 120 | t pour 1 % de déformation | 32 h | 182 h | 260 h | 151 h |
| | | t à rupture | 100 h | 335 h | 400 h | 260 h |

Fig.3    CARACTERISTIQUES DE FLUAGE